(19) Europäisches Patentamt
European Patent Office
Office européen des brevets

(11) **EP 2 803 397 B1**

(12) **EUROPEAN PATENT SPECIFICATION**

(45) Date of publication and mention
of the grant of the patent:
**11.04.2018 Bulletin 2018/15**

(51) Int Cl.:
***C07F 5/06*** *(2006.01)*     ***B01D 1/22*** *(2006.01)*
***B01D 7/02*** *(2006.01)*

(21) Application number: **14166693.3**

(22) Date of filing: **30.04.2014**

(54) **Apparatus for purifying organicelectroluminescent material and method for purifying organic compound**

Vorrichtung zur Reinigung von organischem elektrolumineszentem Material und Verfahren zur Reinigung einer organischen Verbindung

Appareil de purification de matériau électroluminescent organique et procédé de purification d'un composé organique

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **13.05.2013 KR 20130054062**

(43) Date of publication of application:
**19.11.2014 Bulletin 2014/47**

(73) Proprietor: **CHEIL INDUSTRIES INC.
Gumi-si,
Gyeongsangbuk-do 730-710 (KR)**

(72) Inventors:
• **Choi, Sang June**
  **Gyeonggi-do (KR)**
• **Yoo, Hyeong Guk**
  **437-711 Gyeonggi-do (KR)**
• **Jeong, Hee Jun**
  **437-711 Gyeonggi-do (KR)**
• **Kang, Myeong Soon**
  **437-711 Gyeonggi-do (KR)**
• **Yoon, Hae Sang**
  **437-711 Gyeonggi-do (KR)**

(74) Representative: **Michalski Hüttermann & Partner
Patentanwälte mbB
Speditionstraße 21
40221 Düsseldorf (DE)**

(56) References cited:
**FR-A1- 2 704 446     GB-A- 509 242
US-A- 1 445 870     US-A- 2 628 892
US-A- 3 034 573     US-A- 3 840 349**

## Description

## Field of the Invention

The present invention relates to an apparatus and method for purifying an organic compound, and more particularly, to an apparatus and method for purifying an organic compound used in manufacture of an organic electroluminescent device.

## Description of the Related Art

In general, an organic electroluminescent device emits light through recombination of electrons and holes in an organic film formed between an electron injection electrode (i.e. a negative electrode) and a hole injection electrode (i.e. a positive electrode) when electric charges are injected into the organic film, and has characteristics, such as low voltage operation, low power consumption, and the like.

US 3 840 349 A refers to forms of a rotatable sublimation apparatus for separating or purifying chemicals. A tubular member containing a sample to be sublimed is heated by a heating coil helically wound on another tube. The tubes are coaxial, either within the other, and they rotate relatively, generally one rotatable and the other stationary. Also disclosed are several chemical separations by sublimation using the apparatus, e.g., the purification of tetracene and 2-chloroanthracene and the separation of chrysene and 2,3-benzocarbazole.

US 2 628 892 A refers to to an apparatus for increasing the concentration of one component in a mixture of difficultly separable components, at least one of which passes from the solid phase into the vapor phase without becoming a liquid.

US 1 445 870 A refers to a sublimating apparatus comprising a long cylindrical member providing a vaporizing chamber disposed substantially horizontal, a heating element arranged within said chamber and extending lengthwise thereof, a crude-material inlet arranged adjacent one end of said member, vapor outlet also arranged in said member adjacent one end thereof, means for causing the crude material to travel axially along said member and around the periphery thereof toward said other end, in close proximity to said heating element, and means for separately extracting the vapors and the waste products from said member.

US 3 034 573 A refers to a vacuum rotary evaporator comprising a glass vessel having an aperture therein; a straight tube made of non-machined glass tubing and having an upper and a lower end and an opening at each end and having throughout its entire length a bore free from internal obstructions and of a diameter approximating that of the aperture in the vessel, said tube being detachably secured to said vessel, the opening at the lower end of the tube communicating with the aperture in the vessel; tube-rotating means engaging said tube on its external surface, a non-rotating vapor off-take connected to the opening at the upper end of the tube, a vacuum source, an elastic vacuum tube between said vacuum source and said vapor off-take, and an annular packing member of elastic material between the off-take and the external surface of the tube exclusively below the opening of the latter at the upper end thereof, said non-rotating vapor off-take being thereby floatingly connected to the upper end of said tube so that said off-take can adapt itself to lateral displacement of the rotating tube, while maintaining a sufficiently tight sealing effect of said packing member at all times, whereby contamination of the vapors leaving through said off-take with substance from said packing member is substantially avoided.

GB 509 242 A refers to an apparatus and a process of concentrating homo dispersed sols and suspensions , wherein the substance looming the suspension or emulsion and genuinely dissolved in inorganic solvent is quickly and preferably concentrated with continuous agitation in a rotating cylindrical evaporator after having been introduced in a comparatively great volume of the aqueous medium.

FR 2 704 446 A1 refers to a a process for the treatment of polluted water or for drying various sludges employing a thermodynamic cycle in order to perform the evaporation of the water at an extremely low energy cost and to a device that comprises a metal belt stretched between two pulleys, a compressor, drawing the water vapour into the vessel E1, in order to compress it in the vessel E2 where it is condensed under the upper strand of the belt, means and for layering a fine coat of sludge on the upper part of the said strand, a rotary airlock for extracting the dry matter scraped by means and finally exchangers and for saving energy.

The organic electroluminescent device is a flat panel display based on a phenomenon wherein light is emitted through conversion of electric energy into light energy when direct current (DC) voltage is applied to a stacked layer of organic materials.

An organic compound used for such an organic electroluminescent device must be purified. Here, a technique for purification of the organic compound separates only a pure pigment component from the organic compound to use the pigment component for thin film deposition. With the development of the technique for purification of the organic compound, color purity and luminous efficacy have been improved, and luminescence lifetime of the organic electroluminescent device has also been extended. For mass production of the organic compound, a purifying technique capable of improving speed, purity and yield is necessary.

In this regard, one example of the background technique there is disclosed in Korean Patent No. 0497448 (registered on June 16, 2005 and entitled "Method for refining organic electro luminescence material using chelating agent").

**Summary of the Invention**

In accordance with one aspect of the present invention, an apparatus according to claim 1 is claimed for purifying an organic compound includes:

> a supply unit;
> an inner tube for receiving a purification target material therein, wherein the supply unit is located in the inner tube;
> a heater for heating the purification target material received in the inner tube;
> an evacuator for evacuating the inner tube into a vacuum; and
> a driving device for driving the inner tube,
> wherein at least one collecting unit is disposed between the supply unit and the evacuator,
> wherein the collecting unit is divided into a plurality of zones, wherein the zones are to be heated by a collecting unit-heating portion including a plurality of collecting unit-heating portions independently controlling the temperature of the collecting unit.

In accordance with another aspect of the present invention, a method for purifying an organic compound includes: (a) supplying a purification target material to a supply unit; (b) melting the purification target material; (c) rotating the supply unit to form a thin film on an inner wall of the supply unit; (d) heating the purification target material supplied to the supply unit to be sublimated or evaporated; and (e) purifying the purification target material by sublimating or liquefying the purification target material while moving the purification target material toward an evacuator.

**Brief Description of the Drawings**

> FIG. 1 is a schematic view of an apparatus for purifying an organic compound in accordance with a first embodiment of the present invention.
> FIG. 2 is a sectional view of a deposition portion in accordance with the first embodiment of the present invention, showing a deposited state of a thin film thereon.
> FIG. 3 is a perspective view showing coupling between a supply unit and a power transmission unit in accordance with the first embodiment of the present invention.
> FIG. 4 is an enlarged view of Part A in FIG. 3.
> FIG. 5 is a sectional view of Part A in FIG. 3.
> FIG. 6 is a flowchart of a method for purifying an organic compound in accordance with the first embodiment of the present invention.
> FIG. 7 is a schematic view of an apparatus for purifying an organic compound in accordance with a second embodiment of the present invention.
> FIG. 8 is a schematic view of an apparatus for purifying an organic compound in accordance with a third embodiment of the present invention.
> FIG. 9 is a schematic view of an apparatus for purifying an organic compound in accordance with a fourth embodiment of the present invention.

**Detailed description of the Invention**

In accordance with one aspect of the present invention, an apparatus for purifying an organic compound according to claim 1 includes: an inner tube receiving a purification target material therein; a heater heating the purification target material received in the inner tube; an evacuator evacuating the inner tube into a vacuum; and a driving device driving the inner tube.

The inner tube includes a supply unit to which the purification target material is supplied; and a collecting unit in which the purification target material moving toward the evacuator is sublimated or liquefied.

The inner tube includes a collecting unit disposed between the supply unit and the evacuator. The collecting unit is divided into a plurality of zones and is disposed between the supply unit and the evacuator. The zones are to be heated by the collecting unit-heating portion including a plurality of collecting unit-heating portions independently controlling the temperature of each zone of the collecting unit. The apparatus may further include a buffer placed between the supply unit and the collecting unit and collecting foreign matter from the purification target material sublimated or evaporated in the supply unit.

The supply unit may include: a discharge port open toward the collecting unit and discharging the sublimated or evaporated purification target material toward the collecting unit; and a deposition portion storing the purification target material and having an inner wall on which the purification target material is deposited as a thin film. Here, the discharge port has a greater height than the deposition portion.

The driving device may include a drive unit generating power; and a power transmission unit transmitting the power generated by the drive unit to the supply unit to move the supply unit.

The power transmission unit may rotate the supply unit.

The power transmission unit may include: a power transmission member receiving power from the drive unit; and a supply unit-holding member transmitting power received in cooperation with the power transmission member to the supply unit.

The supply unit-holding member may include: an outward holding portion extending to surround an outer surface of the supply unit; and a longitudinal holding portion extending in a longitudinal direction of the supply unit and formed to intersect the outward holding portion.

The apparatus may further include: a mounting portion placed on at least one of the outward holding portion and the longitudinal holding portion; a pressing portion placed on the mounting portion and supporting the supply unit; and a resilient portion pressing the pressing portion toward the supply unit.

The supply unit-holding member may be separated from the supply unit, the mounting portion may be penetratingly formed, and the pressing portion may be disposed to contact the supply unit.

The supply unit may be detachably coupled to the power transmission unit.

The heater may heat the purification target material placed in the supply unit to be sublimated or evaporated, and may heat the purification target material moving along the collecting unit to be sublimated or liquefied.

The heater may include: a supply unit-heating portion heating the supply unit; and a collecting unit-heating portion heating the collecting unit. Here, the collecting unit-heating portion heats the collecting unit to a lower temperature than the supply unit-heating portion.

The inner tube may be divided into a plurality of zones to be heated from a side of the driving device to a side of the evacuator, and the heater may heat the inner tube such that the zone closest to the driving device has the highest temperature.

The apparatus may further include: an outer tube accommodating the inner tube, the outer tube being provided at one side thereof with the driving device and at the other side thereof with the evacuator, and a sealing portion sealing a coupling portion between the driving device and the outer tube to seal the outer tube.

The apparatus may further include: a carrying gas supplier supplying a carrying gas to move the sublimated or evaporated purification target material toward the evacuator.

The inner tube may include a surface-area enlarging portion to enlarge a surface area inside the inner tube.

According to another aspect of the present invention, a method for purifying an organic compound includes: (a) supplying a purification target material to a supply unit; (b) melting the purification target material; (c) rotating the supply unit to form a thin film on an inner wall of the supply unit; (d) heating the purification target material supplied to the supply unit to be sublimated or evaporated; and (e) purifying the purification target material by sublimating or liquefying the purification target material while moving the purification target material toward an evacuator.

The step of (a) may include inserting the supply unit into an outer tube and then blocking the supply unit from external air using a sealing portion.

The step of (d) may include heating the inner tube divided into a plurality of zones such that the zone farthest away from the evacuator has a temperature equal to or higher than a sublimation or evaporation point of the purification target material and the other zones have a temperature lower than the sublimation or evaporation point.

The step of (d) may include heating the plurality of zones to have different temperature gradients.

The step of (c) may include rotating the supply unit after completely melting the purification target material.

Hereinafter, embodiments of the present invention will be described in detail with reference to the accompanying drawings. It should be noted that the drawings are not to precise scale and may be exaggerated in thickness of lines or size of components for convenience and clarity.

In a first embodiment of the invention, a purification target material F is an organic compound and may include, for example, a material for organic optoelectric devices. Here, the organic compound may include not only a pure organic compound but also a composite organic/inorganic compound, i.e. an organometallic complex compound. For example, the organic compound according to the present invention may include organic compounds for medicines, organic compounds for electronic materials, and organic compounds for chemical materials. However, it should be understood that the purification target material F according to the present invention is not limited thereto, and may be replaced by other materials, as needed.

The organic optoelectric device is not particularly restricted so long as it can convert electric energy into light energy, or vice versa. The organic optoelectric device refers to a device that requires exchange of electric charges between an electrode and an organic material using holes or electrons. The organic optoelectric device may be broadly classified into two types in accordance with operation. The first type is an electronic device in which an exciton is generated in an organic layer by a photon introduced from an external light source into the device and is divided into an electron and a hole, which in turn are transported to different electrodes to be used as a current source. The second type is an electronic device in which voltage or current is deposited to two or more electrodes so as to inject holes or electrons into an organic semiconductor forming an interface with the electrodes, and which is operated by the injected electrons and holes.

Examples of the organic optoelectric device include an organic electroluminescent device, an organic light emitting device, an organic solar cell, an organic photo conductor drum, an organic transistor, and the like, all of which require a hole injection or transport material, an electron injection or transport material, or a light emitting material to drive the device.

A material for the organic optoelectric device according to a first embodiment is a material for an organic light emitting diode (OLED). Among the materials for the organic light emitting diode, examples of organic compounds (i.e., a composite organic/inorganic compound, such as an organic metal composite compound) include organic compounds for a dopant, a host, an auxiliary hole transport layer, a hole transport layer, a hole injection layer, an electron injection layer, an auxiliary electron transport layer, an electron transport layer and the like, and the purification target material according to the present invention may be one thereamong, but is not limited thereto.

Examples of the material that may be used to form the electron transport layer may include quinoline, 2-(4-biphenylyl)-5-(4-t-butylphenyl)-1,3,4-oxadiazole (PBD), 4,7-diphenyl-1,10-phenanthroline (Bphen), tris(8-hydroxyquinoline)aluminum (Alq3), beryllium bis(benzoquinolin-10-olate) (Bebq2), etc.

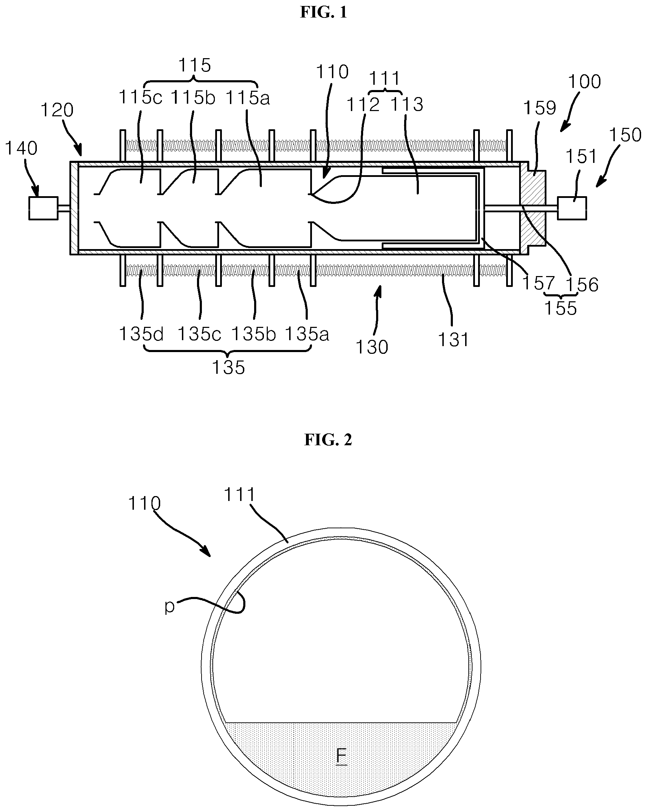

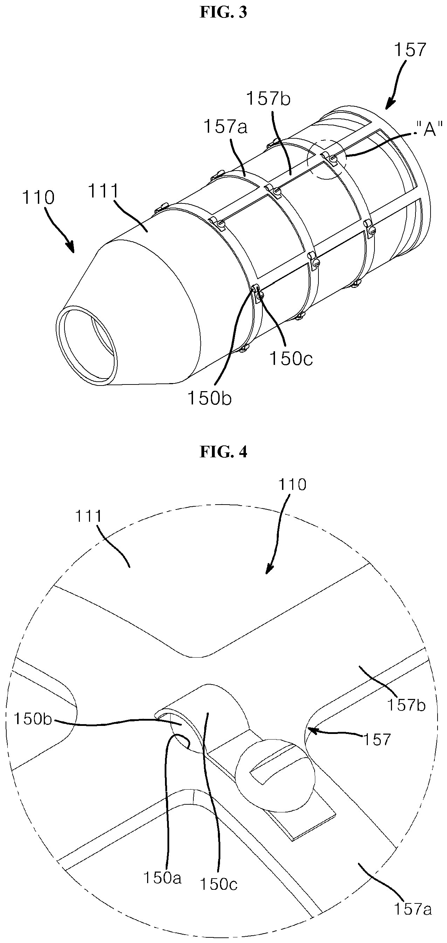

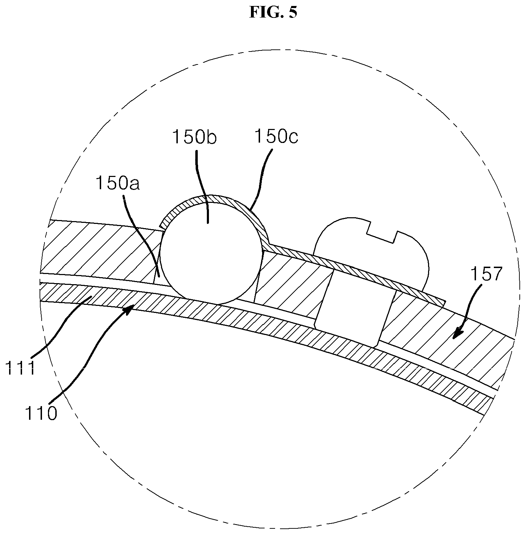

FIG. 1 is a schematic view of an apparatus for purifying an organic compound in accordance with a first embodiment of the present invention, and FIG. 2 is a sectional view of a deposition portion in accordance with the first embodiment of the present invention, showing a deposited state of a thin film thereon. In addition, FIG. 3 is a perspective view showing coupling between a supply unit and a power transmission unit in accordance with the first embodiment of the present invention, FIG. 4 is an enlarged view of Part A in FIG. 3, and FIG. 5 is a sectional view of Part A in FIG. 3.

Referring to FIG. 1, an apparatus 100 for purifying an organic compound according to a first embodiment of the invention includes an inner tube 110, an outer tube 120, a heater 130, an evacuator 140, and a driving device 150.

The inner tube 110 receives a purification target material. In this embodiment, the inner tube 110 is rotatable and receives the purification target material therein. The inner tube 110 includes a supply unit 111 and a collecting unit 115.

The purification target material is supplied to the supply unit 111. The supply unit 111 corresponds to a section of the inner tube 110 closest to the driving device 150 (described below), and includes a discharge port 112 and a deposition portion 113.

In this embodiment, the supply unit 111 is formed of quartz and has a circular tube shape, which is open at one side thereof and is closed at the other side thereof. The discharge port 112 may be open toward the collecting unit 115 at one side of the supply unit 111 such that the supply unit 111 is open toward the collecting unit 115 (described below).

Referring to FIGs. 1 and 2, the deposition portion 113 corresponds to a portion including a cylindrical shape of the supply unit 111. The deposition portion 113 stores the purification target material therein, and the purification target material stored in the deposition portion 113 is heated and melted in the deposition portion 113. The purification target material melted in the deposition portion 113 is deposited as a thin film to an inner wall of the deposition portion 113 and sublimated or evaporated, upon operation of the supply unit 111, specifically, upon rotation of the supply unit 111.

In this embodiment, the melted purification target material F is deposited as a thin film p over the inner wall of the deposition portion 113 as the supply unit 111 is rotated by the driving device 150 with the purification target material melted in the deposition portion 113. Such a thin film p of the purification target material on the inner wall of the deposition portion 113 serves to enlarge a surface area through which the purification target material is sublimated or evaporated, whereby the purification target material can be relatively quickly and efficiently sublimated or evaporated at the same temperature.

In the deposition portion 113, the sublimated or evaporated purification target material is discharged toward the collecting unit 115 through the discharge port 112. The discharge port 112, through which the sublimated or evaporated purification target material is discharged, may have a greater height than the deposition portion 113. According to this embodiment, since the supply unit 111 is operated to rotate, the discharge port 112 has a greater height than the deposition portion 113 to prevent the purification target material F stored and melted in the deposition portion 113 from running over to an outside of the supply unit 111 during rotation of the supply unit 111.

In the collecting unit 115, the purification target material is sublimated or liquefied while moving toward the evacuator 140. The collecting unit 115 is disposed between the supply unit 111 and the evacuator 140. Here, at least one collecting unit 115 is disposed between the supply unit 111 and the evacuator 140.

According to this embodiment, three collecting units 115a, 115b, 115c are disposed between the supply unit

111 and the evacuator 140. With this, the purification target material having the highest purity is sublimated or liquefied in a first collecting unit 115a closest to the supply unit 111, and the purification target material having the lowest purity and foreign matter are sublimated or liquefied in a third collecting unit 115c closest to the evacuator 140. Further, the purification target material having the same purity as the first collecting unit 115a and containing more foreign matter are sublimated or liquefied in a second collecting unit 115b placed between the first collecting unit 115a and the third collecting unit 115c.

According to this embodiment, the three collecting units 115a, 115b, 115c are disposed between the supply unit 111 and the evacuator 140, without being limited thereto. Alternatively, one or two collecting units 115, or four or more collecting units may be disposed therebetween, and various modifications can be made according to properties, heating temperature, and pressure of the purification target material.

The outer tube 120 is disposed outside the inner tube 110. That is, the inner tube 110 is accommodated in the outer tube 120. The outer tube 120 is provided at one side thereof with the driving device 150 and at the other side thereof with the evacuator 140.

The heater 130 heats the purification target material placed in the inner tube 110. The heater 130 heats the purification target material placed in the supply unit 111 to be sublimated or evaporated, and heats the purification target material moving along the collecting unit 115 to be sublimated or liquefied.

In this embodiment, the heater 130 includes a supply unit-heating portion 131 and a collecting unit-heating portion 135. The supply unit-heating portion 131 is disposed at a side of the supply unit 111 and heats the supply unit 111 such that the purification target material placed in the supply unit 111 can be sublimated or evaporated. Likewise, the collecting unit-heating portion 135 is disposed at a side of the collecting unit 115 and heats the collecting unit 115 such that the collecting unit 115 has a temperature lower than the supply unit-heating portion 131, thereby heating the purification target material moving along the collecting unit 115 to be sublimated or liquefied in the collecting unit 115.

In addition, the inner tube 110 is divided into a plurality of zones to be heated from the driving device 150 toward the evacuator 140, and the heater 130 heats the inner tube 110 such that the zone closest to the driving device 150 has the highest temperature. With this structure, the inner tube 110 is heated in a state of being divided into a zone corresponding to the supply unit 111 heated by the supply unit-heating portion 131 and a zone corresponding to the collecting unit 115 heated by the collecting unit-heating portion 135, in which the zone corresponding to the supply unit 111 closest to the driving device 150 has the highest temperature.

In addition, the collecting unit 115 of the inner tube 110 is divided into a plurality of zones to be heated by the collecting unit-heating portion 135, and the collecting unit-heating portion 135 includes a plurality of collecting unit-heating portions 135a, 135b, 135c, 135d arranged in a longitudinal direction of the collecting unit 115 and independently controlling the temperature.

Here, a zone corresponding to the first collecting unit 115a is heated by first collecting unit-heating portions 135a, 135b, a zone corresponding to the second collecting unit 115b is heated by second collecting unit-heating portion 135c, and a zone corresponding to the third collecting unit 115c is heated by a third collecting unit-heating portion 135d such that the temperatures thereof can be independently controlled.

Accordingly, the collecting unit 115 is heated by the collecting unit-heating portion 135 in a state of divided into a plurality of zones from the driving device 150 to the evacuator 140, in which a zone closest to the driving device 150, i.e., the zone corresponding to the first collecting unit 115a, is heated to the highest temperature.

Alternatively, the inner tube 110 may be heated by dividing the supply unit 111 into a plurality of zones, or by dividing both the supply unit 111 and the collecting unit 115 into a plurality of zones. Even in this case, the heater 130 heats the inner tube 110 such that the zone closest to the driving device 150 has the highest temperature.

With this heating structure for the inner tube 110, the purification target material is sublimated or evaporated in the supply unit 111 and the purification target material is sublimated or liquefied in the collecting unit 115, in which materials having different properties, for example, different amounts of foreign matter, are sublimated or liquefied to be respectively collected in the plurality of zones formed by dividing the collecting unit 115.

The evacuator 140 evacuates the inner tube 110 into a vacuum. The evacuator 140 is placed at the other side of the outer tube 120 and evacuates the outer tube 120, which receives the inner tube 110 therein, thereby providing a minute pressure gradient in the respective zones of the inner tube 110.

As the inner tube 110 is evacuated by the evacuator 140, the purification target material placed onside the inner tube 110 can be sublimated or evaporated in a vacuum at a temperature lower than the temperature of the purification target material sublimated or evaporated at atmospheric pressure. Further, in the supply unit 111, the sublimated or evaporated purification target material moves according to the pressure gradient caused by operation of the evacuator 140, and is re-sublimated or liquefied to be collected in the collecting unit 115.

The driving device 150 drives the inner tube 110. The driving device 150 includes a drive unit 151 and a power transmission unit 155.

The drive unit 151 generates power for operating the inner tube 110. In this embodiment, the drive unit 151 generates torque for rotating the inner tube 110.

The power transmission unit 155 transmits the power generated by the drive unit 151 to the supply unit 111 to move the supply unit 111. In this embodiment, the power transmission unit 155 transmits torque for rotating the supply unit 111 to the supply unit 111. The power transmission unit 155 includes a power transmission member 156 and a supply unit-holding member 157.

The power transmission member 156 connects the drive unit 151 to the supply unit-holding member 157 such that power can be transmitted from the drive unit 151 to the supply unit-holding member 157. In this embodiment, the power transmission member 156 is rotated by the drive unit 151 and thus rotates the supply unit-holding member 157.

Referring to FIGs. 1 to 3, the supply unit-holding member 157 receives power in cooperation with the power transmission member 156 and transmits the power to the supply unit 111. In this embodiment, the supply unit-holding member 157 is rotated in cooperation with the power transmission member 156 and rotates the supply unit 111. The supply unit-holding member 157 includes an outward holding portion 157a and a longitudinal holding portion 157b.

The outward holding portion 157a extends to surround an outer surface of the supply unit 111. The outward holding portion 157a extends to surround the outer surface of the supply unit 111 in a circumference direction thereof, and includes a plurality of outward holding portions separated from each other and arranged in the longitudinal direction of the supply unit 111.

The longitudinal holding portion 157b extends in the longitudinal direction of the supply unit 111 and is formed to intersect the outward holding portion 157a. The longitudinal holding portion 157b includes a plurality of longitudinal holding portions separated from each other and arranged in the circumferential direction of the supply unit 111, and intersects the outward holding portion 157a.

The apparatus 100 according to this embodiment may further include a mounting portion 150a, a pressing portion 150b, and a resilient portion 150c, as shown in FIGs. 3 to 5.

According to this embodiment, the supply unit-holding member 157 is separated from the supply unit 111 and the mounting portion 150a is formed to pass through at least one of the outward holding portion 157a and the longitudinal holding portion 157b of the supply unit-holding member 157. According to this embodiment, the mounting portion 150a is penetratingly formed at an intersection between the outward holding portion 157a and the longitudinal holding portion 157b.

The pressing portion 150b is placed on the mounting portion 150a and supports the supply unit 111. In this embodiment, the pressing portion 150b is formed in a shape, such as a spherical shape. The pressing portion 150b is formed in a through-hole of the mounting portion 150a and is movable in a direction of approaching or moving away from the supply unit 111, such that the pressing portion 150b can contact the supply unit 111 and support the supply unit 111 on the supply unit-holding member 157 in a state of being separated from the supply unit-holding member 157.

The resilient portion 150c presses the pressing portion 150b toward the supply unit 111. In this embodiment, the resilient portion 150c is adjacent to the mounting portion 150a and provided in the form of a leaf spring, which is secured at one side thereof to the supply unit-holding member 157 and has the other side contacting the pressing portion 150b and elastically pressing the pressing portion 150b toward the supply unit 111. The resilient portion 150c elastically presses the pressing portion 150b toward the supply unit 111 such that the pressing portion 150b can support the supply unit 111 in a state of being separated from the supply unit-holding member 157.

As described above, an assembly of the pressing portion 150b movably placed on the mounting portion 150a and the resilient portion 150c elastically pressing the pressing portion 150b toward the supply unit 111 serves not only as a coupling medium for detachably coupling the supply unit 111 and the power transmission unit 155 (see FIG. 1), but also allows the supply unit 111 and the power transmission unit 155 formed of different materials and having different coefficients of thermal expansion to be coupled to each other without contact.

Such an assembly of the pressing portion 150b and the resilient portion 150c is changed in shape corresponding to change in shape due to thermal expansion of the supply unit 111 or the power transmission unit 155 and thus stably maintains coupling between the supply unit 111 and the power transmission unit 155 even in the case where the supply unit 111 and the power transmission unit 155 heated together with the purification target material to be sublimated or evaporated are different in degree of thermal expansion.

For example, when the supply unit 111 is formed of quartz and the power transmission unit 155 is formed of metal such as stainless steel, even in the case where the power transmission unit 155 formed of a material having a relatively high coefficient of thermal expansion is more expanded than the supply unit 111 and thus a gap is formed between the supply unit 111 and the power transmission unit 155, the coupling portion between the supply unit 111 and the power transmission unit 155 is stably supported by the assembly of the pressing portion 150b and the resilient portion 150c, whereby the supply unit 111 can be stably rotated without being shaken.

Further, in the apparatus 100 according to this embodiment as shown in FIG. 1, the supply unit 111 is detachably coupled to the power transmission unit 155, and the assembly of the inner tube 110 and the driving device 150 is detachably coupled to the outer tube 120.

Thus, the supply unit 111 can be easily repaired or replaced by detaching the same from the power transmission unit 155 and the purification target material can be supplied to the supply unit 111 after separating the inner tube 110 from the outer tube 120.

The coupling portion between the driving device 150 and the outer tube 120 includes a sealing portion 159. The sealing portion 159 seals the coupling portion between the driving device 150 and the outer tube 120 to seal the outer tube 120, thereby maintaining the outer tube 120 and the inner tube 110 in a vacuum.

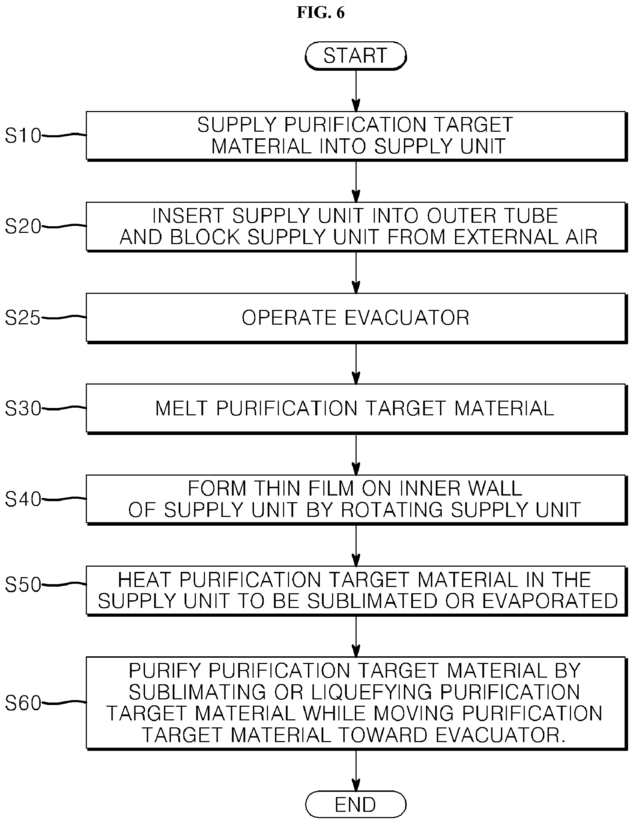

FIG. 6 is a flowchart of a method of purifying an organic compound using the apparatus in accordance with the first embodiment of the present invention.

Hereinafter, operation and effects of the apparatus and method for purifying an organic compound in accordance with the first embodiment of the present embodiment will be described with reference to FIGs. 1 to 6.

Referring to FIGs. 1 to 6, to purify a purification target material using the apparatus 100 according to this embodiment, the purification target material is first supplied into the supply unit 111 (S10). Supply of the purification target material into the supply unit 111 may be achieved by directly placing the purification target material into the supply unit 111, after the assembly of the supply unit 111 and the driving device 150 are removed from the outer tube 120, or by providing the purification target material to the deposition portion 113 via the discharge port 112 after the supply unit 111 is separated from the supply unit-holding member 157. In this embodiment, the purification target material is a material for an electron transport layer (ETL).

As described above, when the supply unit 111 receives the purification target material, the supply unit 111 is inserted into and coupled to the supply unit-holding member 157 and inserted into the outer tube 120, and then the sealing portion 159 is used to block the supply unit 111 from external air (S20). In this state, the evacuator 140 is operated to evacuate the inner tube 110 into a vacuum while forming a minute pressure gradient in the respective sections of the inner tube 110 (S25).

Thereafter, the heater 130 is operated to melt the purification target material in the supply unit 111 (S30). According to this embodiment, the purification target material supplied to the supply unit 111, specifically, to the deposition portion 113, is heated and melted in the deposition portion 113 as the supply unit 111 is heated by the supply unit-heating portion 131 placed at a side of the supply unit 111.

In the heater 130, only the supply unit-heating portion 131 is operated to heat only the zone corresponding to the supply unit 111, or both the supply unit-heating portion 131 and the collecting unit-heating portion 135 are operated to heat both the supply unit 111 and the collecting unit 115.

As described above, when the purification target material is partially or completely melted, the supply unit 111 is rotated such that a thin film p can be formed on the inner wall of the supply unit 111, i.e., on the inner wall of the deposition portion 113 (S40). According to this embodiment, the supply unit 111 may be rotated by operation of the driving device 150. Further, the purification target material F melted in the deposition portion 113 may be deposited as a thin film p on the inner wall of the deposition portion 113 while sequentially contacting the inner wall of the deposition portion 113 in a direction of rotating the supply unit 111 upon rotation of the supply unit 111.

According to this embodiment, since the discharge port 112 has a greater height than the deposition portion 113, the purification target material F stored and melted in the deposition portion 113 does not flow toward an outside of the supply unit 111 during rotation of the supply unit 111.

According to this embodiment, the supply unit 111 is rotated after the purification target material is completely melted. However, the present invention is not limited thereto. Alternatively, the supply unit 111 may be rotated while the purification target material is partially melted, and various modifications can be made.

While the purification target material is formed as a thin film p on the inner wall of the deposition portion 113 through rotation of the supply unit 111, the purification target material supplied to the supply unit 111 is heated to be sublimated or evaporated (S50).

Such heating is achieved by the heater 130, and more particularly, heating of the purification target material supplied to the supply unit 111 to be sublimated or evaporated is achieved by the supply unit-heating portion 131. The supply unit-heating portion 131 heats the supply unit 111 to a temperature equal to or higher than a sublimation point or evaporation point of the purification target material such that the purification target material supplied to the supply unit 111 can be sublimated or evaporated.

Since the inner tube 110 is evacuated into a vacuum by the evacuator 140, the purification target material can be sublimated or evaporated in a vacuum at a temperature lower than the purification target material sublimated or evaporated at atmospheric pressure.

According to this embodiment, since the driving device 150 rotates the supply unit 111 in the state that the purification target material is melted in the deposition portion 113, the purification target material is deposited as a thin film over the inner wall of the deposition portion 113. Such a thin film of the purification target material on the inner wall of the deposition portion 113 serves to enlarge the surface area of the purification target material to be sublimated or evaporated, and thus, the purification target material can be more quickly and efficiently sublimated or evaporated under the same temperature conditions.

Such heating is achieved to allow the respective zones of the inner tube 110 to have different temperature gradients. Thus, the heater 130 heats the zone of the inner tube 110 farthest away from the evacuator 140 among the plurality of zones formed by dividing the inner tube 110 to have a temperature equal to or higher than the sublimation or evaporation point of the purification target material, and heats the other zones of the inner tube 110 to have a temperature lower than the sublimation or evaporation point thereof, in which the temperature gradient shows that the temperature of the inner tube 110 is gradually lowered from the zone of the inner tube 110 farthest from the evacuator 140 to the zone of the inner tube 110 closest to the evacuator 140.

That is, the supply unit 111 is heated by the supply unit-heating portion 131 to a temperature equal to or higher than the sublimation or evaporation point of the purification target material, and the collecting unit 115 is heated by the collecting unit-heating portion 135 to a temperature lower than the sublimation or evaporation point of the purification target material, in which the temperature gradient shows that the temperature of the collecting unit 115 is gradually lowered from the zone of the collecting unit 115 farthest from the evacuator 140 to the zone of the collecting unit 115 closest to the evacuator 140.

The foregoing heating operation may be achieved by first heating the supply unit 111 and then heating the collecting unit 115 with a time lag therebetween, or by simultaneously heating both the supply unit 111 and the collecting unit 115.

When the purification target material is heated as above to be sublimated or evaporated, the purification target material is sublimated or liquefied for purification while moving the purification target material toward the evacuator 140 (S60).

According to this embodiment, movement of the sublimated or evaporated purification target material in the supply unit 111 is achieved along a minute pressure gradient formed in the inner tube 110 by operation of the evacuator 140. While the purification target material moves along the pressure gradient, the purification target material is sublimated or liquefied in each corresponding zone of the controller 115 heated to a temperature range of a sublimation or evaporation point of a target product.

For example, a material having the highest purity is sublimated or liquefied to be collected in a zone of the first collecting unit 115a heated to have the highest temperature within a temperature range lower than the sublimation or evaporation point of the purification target material, a material having the same purity as that of the first collecting unit 115a or containing more foreign matter is sublimated or liquefied to be collected in a zone of the second collecting unit 115b heated to have a temperature gradually lower than that of the first collecting unit 115a, and foreign matter is collected in a zone of the third collecting unit 115c heated to have a temperature lower than that of the second collecting unit 115b.

With the apparatus for purifying an organic compound in accordance with the first embodiment and the method using the same, an experiment of purifying a material for an electron transport layer (ETL) used in manufacture of an organic electroluminescent device was performed.

Experimental Example 1

After 592 g of a material for an ETL(tris(8-hydroxyquinoline)aluminum (Alq3)) was supplied as a purification target material into the supply unit 111 of the inner tube 110, the supply unit 111 was inserted into and coupled to the supply unit-holding member 157 such that the supply unit 111 was placed in a zone to be heated by the supply unit-heating portion 131. And the supply unit 111 was inserted into the outer tube 120, and then the sealing portion 159 is used to block the supply unit 111 from external air.

Thereafter, the evacuator 140 was operated to evacuate the inner tube 110 into a vacuum and the heater 130 was then operated to heat the purification target material in the inner tube 110.

Here, the supply unit-heating portion 131 was heated to 300°C, which is higher than a melting point of the material for the ETL; the first collecting unit-heating portions 135a, 135b of the collecting unit-heating portion 135 were heated to 290°C; the second collecting unit-heating portion 135c was heated to 270°C; the third collecting unit-heating portion 135d was heated to 180°C; and the driving device 150 was operated to rotate the supply unit 111 at a time point when most of the purification target material was melted into a liquid state.

After 3 hours from the beginning point of the experiment, the temperature of the heater 130 was adjusted to start purification. To this end, the supply unit-heating portion 131 was heated to 325°C; the first collecting unit-heating portions 135a, 135b were heated to 320°C, the second collecting unit-heating portion 135c was heated to 260°C, and the third collecting unit-heating portion 135d was heated to 150°C. Here, the temperature of 325°C for heating the supply unit-heating portion 131 is sufficient to evaporate the purification target material.

For comparison with a typical purification method, the materials remaining in the supply unit 111 and the collecting unit 115 upon completion of purification were collected, and time taken for purification, the weight of the purification target material remaining in the supply unit 111, and purity of the material collected in the collecting unit 115 were measured.

Experimental Example 2 and Experimental Example 3

Experimental example 2 and Experimental Example 3 were performed by repeating the procedure of Experimental Example 1 to increase reliability of the experiment, and were performed in the same manner as in Experimental Example 1 except for the amount of the purification target material supplied to the supply unit 111.

That is, the amount of the purification target material in Experimental Example 1 was 592g, while those of Experimental Examples 2 and 3 were 500g and 513g, respectively.

For comparison of the purified materials obtained from the experiments, the materials were collected and processed by the same method as that of Experimental Example 1.

Comparative example

For comparison with the foregoing experiments, an experiment based on a typical purification method was performed as follows.

After the supply unit 111, the driving device 150 and the sealing portion 159 used in Experimental Examples 1, 2 and 3 were removed, a separate supply unit 111 configured not to move and rotate and receiving a purification target material was connected to the collecting unit 115 within the outer tube 120.

500g of a material for an ETL was supplied as a purification target material into the supply unit 111, and the evacuator 140 was operated to evacuate the supply unit 111 into a vacuum. Then, the heater 130 was operated to heat the purification target material placed in the supply unit 111.

The supply unit-heating portion 131 was heated to 300°C, which is higher than a melting point of the material for the ETL; the first collecting unit-heating portions 135a, 135b of the collecting unit-heating portion 135 were heated to 290°C; the second collecting unit-heating portion 135c was heated to 270°C; the third collecting unit-heating portion 135d was heated to 180°C, thereby completely melting the purification target material into a liquid state.

After 3 hours from the beginning point of the experiment, the temperature of the heater 130 was adjusted to start purification. To this end, the supply unit-heating portion 131 was heated to 325°C; the first collecting unit-heating portions 135a, 135b were heated to 320°C, the second collecting unit-heating portion 135c was heated to 260°C, and the third collecting unit-heating portion 135d was heated to 150°C. Here, the temperature of 325°C for heating the supply unit-heating portion 131 is sufficient to evaporate the purification target material.

In order to compare the foregoing experimental examples 1, 2 and 3 with this comparative example, the materials remaining in the supply unit 111 and the collecting unit 115 upon completion of purification is completed were collected, and time taken for purification, the weight of the purification target material remaining in the supply unit 111, and purity of the material collected in the collecting unit 115 were measured.

Results are as shown in the following table 1.

**Table 1**

| | Amount | Time taken for purification | Amount remaining in supply unit | Purifying speed | Speed ratio | Purity | Yield |
|---|---|---|---|---|---|---|---|
| Comparative Example | 500g | 13.0hr | 73.5g | 32.8 g/hr | - | 99.97% | 85.30% |
| Experimental Example 1 | 592g | 5.6hr | 37.0g | 99.1 g/hr | 3.0 times | 99.98% | 93.75% |
| Experimental Example 2 | 500g | 4.0hr | 32.0g | 117.0 g/hr | 3.5 times | 99.98% | 93.60% |
| Experimental Example 3 | 513g | 4.3hr | 33.7g | 111.5 g/hr | 3.4 times | 99.97% | 93.43% |

Purifying speed = [Amount of purification target material supplied to supply unit (g) − remaining amount in supply unit (g)] / Purifying time (hr)

Referring to Table 1, it can be seen that the purified materials prepared in all of Experimental Examples 1, 2 and 3 had higher purity, three or more times faster purifying speeds, and higher yield than the comparative example.

Based on the results shown in Table 1, it was determined that the material having high purity can be obtained at high speed and in high yield through the apparatus and method for purifying an organic compound in accordance with the first embodiment.

As described above, in the apparatus and method for purifying an organic compound in accordance with the first embodiment, the driving device 150 is used to rotate the supply unit 111 such that the purification target material can be deposited as a thin film throughout the inner wall of the deposition portion 113, thereby enlarging the surface area on which the purification target material is sublimated or evaporated, while increasing heat transfer efficiency for the purification target material.

In the apparatus and method for purifying an organic compound in accordance with the first embodiment, since the purification target material is more quickly and efficiently sublimated or evaporated under the same temperature conditions, the purifying speed is increased such that the purification target material can be purified in a more amount per hour under stable conditions than the typical purification method, thereby improving purity and yield.

In addition, in the apparatus and method for purifying an organic compound according to an embodiment, since the supply unit 111 and the power transmission unit 155 are coupled to each other without contact, the supply unit 111 and the power transmission unit 155 can be stably coupled regardless of thermal expansion even though the supply unit 111 and the power transmission unit 155 differ in degree of thermal expansion, thereby preventing shaking during rotation of the supply unit 111.

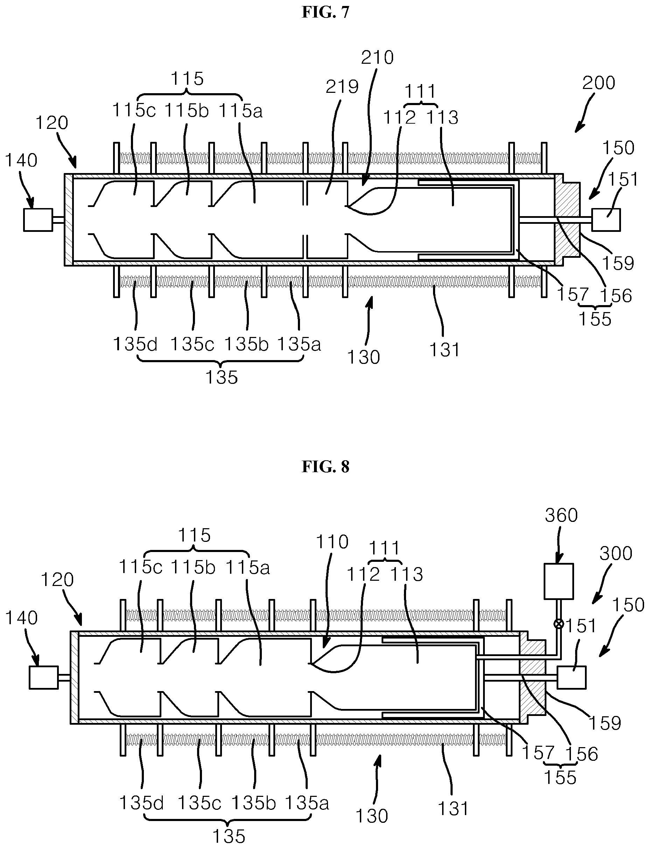

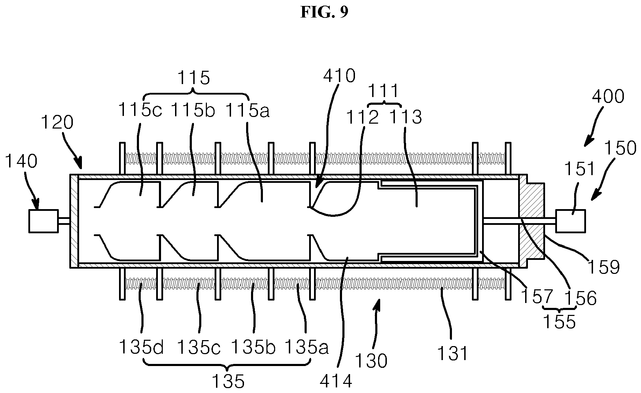

FIG. 7 is a schematic view of an apparatus for purifying an organic compound according to a second embodiment of the present invention, FIG. 8 is a schematic view of an apparatus for purifying an organic compound according to a third embodiment of the present invention, and FIG. 9 is a schematic view of an apparatus for purifying an organic compound according to a fourth embodiment of the present invention.

Next, the apparatus for purifying an organic compound according to second to fourth embodiments of the present invention will be described with reference to FIGs. 7 to 9. Here, like reference numerals refer to like elements having the same functions throughout the drawings, and thus repeated descriptions thereof will be omitted.

Referring to FIG. 7, according to the second embodiment of the invention, an apparatus 200 for purifying an organic compound further includes a buffer 219 in an inner tube 210. The buffer 219 is placed between a supply unit 111 and a collecting unit 115. The buffer 219 collects foreign matter from a purification target material sublimated or evaporated in the supply unit 111. According to this embodiment, a foreign substance having a high molecular weight among the foreign matter of the purification target material falls and is collected in the buffer 219.

Referring to FIG. 8, according to the third embodiment of the present invention, an apparatus 300 for purifying an organic compound further includes a carrying gas supplier 360. The carrying gas supplier 360 supplies a carrying gas for moving the sublimated or evaporated purification target material to the evacuator 140.

Nitrogen gas or similar inert gas may be used as the carrying gas, and the carrying gas supplier 360 supplies the carrying gas to be moved from the driving device 150 toward the evacuator 140, thereby generating a flow for guiding the sublimated or evaporated purification target material toward the evacuator 140.

In the apparatus 300 for purifying an organic compound, which includes the carrying gas supplier 360, according to the third embodiment of the invention, the temperature in respective zones of the heater 130 and the flux of the carrying gas may be controlled to adjust a location in which he purification target material will be collected in the collecting unit 115.

Referring to FIG. 9, according to the fourth embodiment of the present invention, an apparatus 400 for purifying an organic compound further includes a surface-area enlarging portion 414 in an inner tube 410. In this embodiment, the surface-area enlarging portion 414 is convexly expanded from the supply unit 111.

The surface-area enlarging portion 414 improves heating efficiency for the purification target material by enlarging a surface area inside the inner tube 410, i.e., an inner surface area of the supply unit 111, and thus enlarging a heating area for the purification target material supplied to the supply unit 111.

In addition, the supply unit 111 having the surface-area enlarging portion 414 is formed to increase difference in height between the discharge port 112 and the deposition portion 113, whereby the purification target material stored and melted in the deposition portion 113 can be effectively prevented from running to an outside of the supply unit 111 during rotation of the supply unit 111.

**Claims**

**1.** An apparatus (100) for purifying an organic compound, **characterized in that** the apparatus (100) comprises:

   a supply unit (111);
   an inner tube (110) for receiving a purification target material therein, wherein the supply unit (111) is located in the inner tube (110);
   a heater (130) for heating the purification target material received in the inner tube (110);

an evacuator (140) for evacuating the inner tube (110) into a vacuum; a driving device (150) for driving the inner tube (110), a collecting unit, and
a collecting-unit heating portion,
wherein the collecting unit (115) is disposed between the supply unit (111) and
the evacuator (140),
wherein the collecting unit (115) is divided into a plurality of zones, wherein the zones are to be heated by the collecting unit-heating portion (135) including a plurality of collecting unit-heating portions (135a, 135b, 135c, 135d) adapted to independently control the temperature of each zone of the collecting unit (115).

2. The apparatus (100) according to claim 1, wherein the inner tube (110) comprises:

a supply unit (111) configured so that the purification target material is supplied; and
a collecting unit (115) in which the purification target material moving toward the evacuator is sublimated or liquefied.

3. The apparatus (100) according any one of claims 1 or 2, further comprising: a buffer (219) placed between the supply unit (111) and the collecting unit (115) configured so that the buffer (219) collects foreign matter from a purification target material sublimated or liquefied in the supply unit (111).

4. The apparatus (100) according any one of claims 1 to 3, wherein the supply unit (111) comprises:

a discharge port (112) open toward the collecting unit (115) and configured so that the sublimated or evaporated purification target material is discharged toward the collecting unit (115); and
a deposition portion (113) storing the purification target material and having an inner wall on which the purification target material is deposited as a thin film,
the discharge port (112) having a greater height than the deposition portion (113).

5. The apparatus according any one of claims 1 to 4, wherein the driving device comprises:

a drive unit generating power; and
a power transmission unit (155) transmitting the power generated by the drive unit to the supply unit (111) to move the supply unit (111).

6. The apparatus (100) according any one of claims 1 to 5, wherein the power transmission unit (155) rotates the supply unit (111).

7. The apparatus (100) according any one of claims 1 to 6, wherein the power transmission unit (155) comprises:

a power transmission member (156) receiving power from the drive unit; and
a supply unit-holding member (157) transmitting power received in cooperation with the power transmission member (156) to the supply unit (111).

8. The apparatus (100) according to claim 7, wherein the supply unit-holding member (157) comprises:

an outward holding portion extending to surround an outer surface of the supply unit (111); and
a longitudinal holding portion extending in a longitudinal direction of the supply unit (111) and formed to intersect the outward holding portion.

9. The apparatus (100) according any one of claims 1 to 8, further comprising:

a mounting portion (150a) placed on at least one of the outward holding portion and the longitudinal holding portion;
a pressing portion placed on the mounting portion (150a) and supporting the supply unit (111); and
a resilient portion pressing the pressing portion toward the supply unit (111).

10. The apparatus (100) according any one of claims 1 to 9, wherein the supply unit-holding member (157) is separated from the supply unit (111), the mounting portion (150a) is penetratingly formed, and the pressing portion is disposed to contact the supply unit (111).

11. The apparatus (100) according any one of claims 1 to 10, wherein the supply unit (111) is detachably coupled to the power transmission unit (155).

12. The apparatus (100) according any one of claims 1 to 11, wherein the heater (130) comprises:

a supply unit-heating portion (131) for heating the supply unit (111); and
a collecting unit-heating portion (135) for heating the collecting unit (115) configured so that the collecting unit-heating portion (135) is heating the collecting unit (115) to a lower temperature than the supply unit-heating portion (131).

13. The apparatus (100) according any one of claims 1 to 12, further comprising:

an outer tube accommodating the inner tube (110), the outer tube being provided at one side thereof with the driving device (150) and at the other side thereof with the evacuator (140), and
a sealing portion sealing a coupling portion between the driving device (150) and the outer tube to seal the outer tube.

14. The apparatus (100) according any one of claims 1 to 13, further comprising:

a carrying gas supplier supplying a carrying gas and configured so that the sublimated or evaporated purification target material is moved toward the evacuator.

15. The apparatus (100) according any one of claims 1 to 14, wherein the inner tube (110) comprises a surface-area enlarging portion to enlarge a surface area inside the inner tube (110).

16. The apparatus (100) according to any one of claims 1 to 15, wherein the organic compound comprises a material for an organic electroluminescent device.

17. A method of purifying an organic compound using the apparatus of claims 1 to 16, comprising:

(a) supplying a purification target material to a supply unit (111);
(b) melting the purification target material;
(c) rotating the supply unit (111) to form a thin film on an inner wall of the supply unit;
(d) sublimating or evaporating the purification target material supplied to the supply unit by heat; and
(e) purifying the purification target material by sublimating or liquefying the purification target material while moving the purification target material toward an evacuator (140),

wherein (d) heating the purification target material comprises heating the plurality of zones to have different temperature gradients.

18. The method according to claim 17, wherein the (a) supplying a purification target material comprises inserting the supply unit (111) into an outer tube and then blocking the supply unit (111) from external air using a sealing portion.

19. The method according to claim 17 or 18, wherein the (d) heating the purification target material comprises heating the inner tube (110) divided into a plurality of zones such that the zone farthest away from the evacuator (140) has a temperature equal to or higher than a sublimation or evaporation point of the purification target material and the other zones have a temperature lower than the sublimation or evaporation point.

20. The method according any one of claims 17 to 19, wherein the (c) rotating the supply unit (111) comprises rotating the supply unit (111) after completely melting the purification target material.


**Patentansprüche**

1. Vorrichtung (100) zum Reinigen einer organischen Verbindung, **dadurch gekennzeichnet, dass** die Vorrichtung (100) umfasst:

eine Zuführeinheit (111);

ein inneres Rohr (110) zum Aufnehmen eines Reinigungszielmaterials darin, wobei die Zuführeinheit (111) in dem inneren Rohr (110) angeordnet ist;

eine Heizvorrichtung (130) zum Erhitzen des in dem inneren Rohr (110) aufgenommenen Reinigungszielmaterials;

eine Evakuierungsvorrichtung (140) zum Evakuieren des inneren Rohrs (110) zu einem Unterdruck;

eine Antriebsvorrichtung (150) zum Antreiben des inneren Rohrs (110),

eine Sammeleinheit und

einen Sammeleinheit-Heizabschnitt,

wobei die Sammeleinheit (115) zwischen der Zuführeinheit (111) und der Evakuierungsvorrichtung (140) angeordnet ist, wobei die Sammeleinheit (115) in eine Vielzahl von Zonen aufgeteilt ist, wobei die Zonen von dem Sammeleinheit-Heizabschnitt (135) erhitzt werden sollen, der eine Vielzahl von Sammeleinheit-Heizabschnitten (135a, 135b, 135c, 135d) aufweist, die dafür ausgelegt sind, die Temperatur jeder Zone der Sammeleinheit (115) einzeln zu steuern.

2. Vorrichtung (100) gemäß Anspruch 1, wobei das innere Rohr (110) umfasst:

eine Zuführeinheit (111), die so gestaltet ist, dass das Reinigungszielmaterial zugeführt wird; und

eine Sammeleinheit (115), in der das sich in Richtung auf die Evakuierungsvorrichtung bewegende Reinigungszielmaterial sublimiert oder verflüssigt wird.

3. Vorrichtung (100) gemäß einem der Ansprüche 1 oder 2, ferner umfassend: einen Puffer (219), der zwischen der Zuführeinheit (111) und der Sammeleinheit (115) angeordnet ist und so gestaltet ist, dass der Puffer (219) Fremdmaterial aus einem Reinigungszielmaterial sammelt, das in der Zuführeinheit (111) sublimiert oder verflüssigt wird.

4. Vorrichtung (100) gemäß einem der Ansprüche 1 bis 3, wobei die Zuführeinheit (111) umfasst:

eine Auslassöffnung (112), die zu der Sammeleinheit (115) offen ist und so gestaltet ist, dass das sublimierte oder verdampfte Reinigungszielmaterial zu der Sammeleinheit (115) ausgelassen wird; und

einen Abscheidungsabschnitt (113), der das Reinigungszielmaterial speichert und eine Innenwand aufweist, an der das Reinigungszielmaterial als dünner Film abgeschieden wird,

wobei die Auslassöffnung (112) eine größere Höhe als der Abscheidungsabschnitt (113) aufweist.

5. Vorrichtung gemäß einem der Ansprüche 1 bis 4, wobei die Antriebsvorrichtung umfasst:

einen Antrieb, der Kraft erzeugt; und

eine Kraftübertragungseinheit (155), die die von dem Antrieb erzeugte Kraft auf die Zuführeinheit (111) überträgt, um die Zuführeinheit (111) zu bewegen.

6. Vorrichtung (100) gemäß einem der Ansprüche 1 bis 5, wobei die Kraftübertragungseinheit (155) die Zuführeinheit (111) dreht.

7. Vorrichtung (100) gemäß einem der Ansprüche 1 bis 6, wobei die Kraftübertragungseinheit (155) umfasst:

ein Kraftübertragungselement (156), das Kraft von dem Antrieb erhält; und

ein Zuführeinheit-Halteelement (157), das erhaltene Kraft in Zusammenarbeit mit dem Kraftübertragungselement (156) auf die Zuführeinheit (111) überträgt.

8. Vorrichtung (100) gemäß Anspruch 7, wobei das Zuführeinheit-Halteelement (157) umfasst:

einen äußeren Halteabschnitt, der eine Außenoberfläche der Zuführeinheit (111) umgebend verläuft; und

einen längslaufenden Halteabschnitt, der in einer Längsrichtung der Zuführeinheit (111) verläuft und gestaltet ist, den äußeren Halteabschnitt zu kreuzen.

9. Vorrichtung (100) gemäß einem der Ansprüche 1 bis 8, ferner umfassend:

einen Befestigungsabschnitt (150a), der an wenigstens einem von dem äußeren Halteabschnitt und dem längslaufenden Halteabschnitt angeordnet ist;

einen Pressabschnitt, der an dem Befestigungsabschnitt (150a) angeordnet ist und die Zuführeinheit (111) stützt; und
einen elastischen Abschnitt, der den Pressabschnitt zu der Zuführeinheit (111) presst.

10. Vorrichtung (100) gemäß einem der Ansprüche 1 bis 9, wobei das Zuführeinheit-Halteelement (157) von der Zuführeinheit (111) getrennt ist, der Befestigungsabschnitt (150a) durchdringend gestaltet ist und der Pressabschnitt angeordnet ist, um mit der Zuführeinheit (111) Kontakt zu bilden.

11. Vorrichtung (100) gemäß einem der Ansprüche 1 bis 10, wobei die Zuführeinheit (111) lösbar an die Kraftübertragungseinheit (155) gekoppelt ist.

12. Vorrichtung (100) gemäß einem der Ansprüche 1 bis 11, wobei die Heizvorrichtung (130) umfasst:

einen Zuführeinheit-Heizabschnitt (131) zum Heizen der Zuführeinheit (111); und
einen Sammeleinheit-Heizabschnitt (135) zum Heizen der Sammeleinheit (115), der so gestaltet ist, dass der Sammeleinheit-Heizabschnitt (135) die Sammeleinheit (115) auf eine niedrigere Temperatur als der Zuführeinheit-Heizabschnitt (131) erhitzt.

13. Vorrichtung (100) gemäß einem der Ansprüche 1 bis 12, ferner umfassend:

ein äußeres Rohr, das das innere Rohr (110) aufnimmt, wobei das äußere Rohr an einer Seite davon mit der Antriebsvorrichtung (150) und an der anderen Seite davon mit der Evakuierungsvorrichtung (140) versehen ist, und
einen Dichtungsabschnitt, der einen Kopplungsabschnitt zwischen der Antriebsvorrichtung (150) und dem äußeren Rohr abdichtet, um das äußere Rohr abzudichten.

14. Vorrichtung (100) gemäß einem der Ansprüche 1 bis 13, ferner umfassend:

eine Trägergasversorgung, die ein Trägergas zuführt und so gestaltet ist, dass das sublimierte oder verdampfte Reinigungszielmaterial zu der Evakuierungsvorrichtung bewegt wird.

15. Vorrichtung (100) gemäß einem der Ansprüche 1 bis 14, wobei das innere Rohr (110) einen oberflächenvergrößernden Abschnitt umfasst, um eine Oberfläche im Inneren des inneren Rohrs (110) zu vergrößern.

16. Vorrichtung (100) gemäß einem der Ansprüche 1 bis 15, wobei die organische Verbindung ein Material für eine organische elektrolumineszierende Vorrichtung umfasst.

17. Verfahren zum Reinigen einer organischen Verbindung unter Verwendung der Vorrichtung gemäß Ansprüchen 1 bis 16, umfassend:

(a) Zuführen eines Reinigungszielmaterials zu der Zuführeinheit (111);
(b) Schmelzen des Reinigungszielmaterials;
(c) Drehen der Zuführeinheit (111), um einen dünnen Film an einer Innenwand der Zuführeinheit zu bilden;
(d) Sublimieren oder Verdampfen des zu der Zuführeinheit zugeführten Reinigungszielmaterials durch Wärme; und
(e) Reinigen des Reinigungszielmaterials durch Sublimieren oder Verflüssigen des Reinigungszielmaterials unter Bewegen des Reinigungszielmaterials in Richtung auf eine Evakuierungsvorrichtung (140),

wobei (d) Erhitzen des Reinigungszielmaterials Erhitzen der Vielzahl von Zonen umfasst, so dass sie unterschiedliche Temperaturgradienten aufweisen.

18. Verfahren gemäß Anspruch 17, wobei das (a) Zuführen eines Reinigungszielmaterials Einführen der Zuführeinheit (111) in ein äußeres Rohr und dann Abschließen der Zuführeinheit (111) von Außenluft unter Verwendung eines Dichtungsabschnitts umfasst.

19. Verfahren gemäß Anspruch 17 oder 18, wobei das (d) Erhitzen des Reinigungszielmaterials Erhitzen des inneren Rohrs (110) umfasst, das in eine Vielzahl von Zonen unterteilt ist, so dass die Zone, die am weitesten von der Evakuierungsvorrichtung (140) entfernt ist, eine Temperatur von gleich oder höher als ein Sublimations- oder Verdampfungspunkt des Reinigungszielmaterials aufweist und die anderen Zonen eine Temperatur unterhalb des Sublimations- oder Verdampfungspunkts aufweisen.

**20.** Verfahren gemäß einem der Ansprüche 17 bis 19, wobei das (c) Drehen der Zuführeinheit (111) Drehen der Zuführeinheit (111) nach vollständigem Schmelzen des Reinigungszielmaterials umfasst.

## Revendications

**1.** Appareil (100) pour purifier un composé organique, **caractérisé en ce que** l'appareil (100) comprend :

une unité d'alimentation (111) ;
un tube interne (110) pour recevoir un matériau de cible de purification en son sein, dans lequel l'unité d'alimentation (111) est située dans le tube interne (110) ;
un dispositif de chauffage (130) pour chauffer le matériau de cible de purification reçu dans le tube interne (110) ;
un dispositif d'évacuation (140) pour évacuer le tube interne (110) dans un vide ;
un dispositif d'entraînement (150) pour entraîner le tube interne (110),
une unité de collecte et
une partie de chauffage d'unité de collecte,
dans lequel l'unité de collecte (115) est disposée entre l'unité d'alimentation (111) et le dispositif d'évacuation (140),
dans lequel l'unité de collecte (115) est divisée en une pluralité de zones, dans lequel les zones doivent être chauffées par la partie de chauffage d'unité de collecte (135) comprenant une pluralité de parties de chauffage d'unité de collecte (135a, 135b, 135c, 135d) conçues pour réguler de manière indépendante la température de chaque zone de l'unité de collecte (115).

**2.** Appareil (100) selon la revendication 1, dans lequel le tube interne (110) comprend :

une unité d'alimentation (111) configurée de telle sorte que le matériau de cible de purification soit fourni ; et
une unité de collecte (115) dans laquelle le matériau de cible de purification se déplaçant vers le dispositif d'évacuation est sublimé ou liquéfié.

**3.** Appareil (100) selon l'une quelconque des revendications 1 ou 2, comprenant en outre : un tampon (219) placé entre l'unité d'alimentation (111) et l'unité de collecte (115) configuré de telle sorte que le tampon (219) collecte une matière étrangère provenant d'un matériau de cible de purification sublimé ou liquéfié dans l'unité d'alimentation (111).

**4.** Appareil (100) selon l'une quelconque des revendications 1 à 3, dans lequel l'unité d'alimentation (111) comprend :

un orifice d'évacuation (112) ouvert vers l'unité de collecte (115) et configuré de telle sorte que le matériau de cible de purification sublimé ou évaporé soit évacué vers l'unité de collecte (115) ; et
une partie de dépôt (113) stockant le matériau de cible de purification et ayant une paroi interne sur laquelle le matériau de cible de purification est déposé sous la forme d'un mince film,
l'orifice d'évacuation (112) ayant une hauteur plus importante que celle de la partie de dépôt (113).

**5.** Appareil (100) selon l'une quelconque des revendications 1 à 4, dans lequel le dispositif d'entraînement comprend :

une unité d'entraînement générant de la puissance ; et
une unité de transmission de puissance (155) transmettant la puissance générée par l'unité d'entraînement à l'unité d'alimentation (111) pour déplacer l'unité d'alimentation (111).

**6.** Appareil (100) selon l'une quelconque des revendications 1 à 5, dans lequel l'unité de transmission de puissance (155) fait tourner l'unité d'alimentation (111).

**7.** Appareil (100) selon l'une quelconque des revendications 1 à 6, dans lequel l'unité de transmission de puissance (155) comprend :

un élément de transmission de puissance (156) recevant la puissance en provenance de l'unité d'entraînement ;
et

un élément de support d'unité d'alimentation (157) transmettant la puissance reçue en coopération avec l'élément de transmission de puissance (156) à l'unité d'alimentation (111).

8.  Appareil (100) selon la revendication 7, dans lequel l'élément de support d'unité d'alimentation (157) comprend :

    une partie de support extérieure s'étendant de sorte à entourer une surface externe de l'unité d'alimentation (111) ; et
    une partie de support longitudinale s'étendant dans une direction longitudinale de l'unité d'alimentation (111) et formée pour croiser la partie de support extérieure.

9.  Appareil (100) selon l'une quelconque des revendications 1 à 8, comprenant en outre :

    une partie de montage (150a) placée sur la partie de support extérieure et/ou la partie de support longitudinale ;
    une partie de pression placée sur la partie de montage (150a) et supportant l'unité d'alimentation (111) ; et
    une partie élastique pressant la partie de pression vers l'unité d'alimentation (111).

10. Appareil (100) selon l'une quelconque des revendications 1 à 9, dans lequel l'élément de support d'unité d'alimentation (157) est séparé de l'unité d'alimentation (111), la partie de montage (150a) est formée de façon pénétrante et la partie de pression est disposée de sorte à venir en contact avec l'unité d'alimentation (111).

11. Appareil (100) selon l'une quelconque des revendications 1 à 10, dans lequel l'unité d'alimentation (111) est couplée de manière amovible à l'unité de transmission de puissance (155).

12. Appareil (100) selon l'une quelconque des revendications 1 à 11, dans lequel le dispositif de chauffage (130) comprend :

    une partie de chauffage d'unité d'alimentation (131) pour chauffer l'unité d'alimentation (111) ; et
    une partie de chauffage d'unité de collecte (135) pour chauffer l'unité de collecte (115) configurée de telle sorte que la partie de chauffage d'unité de collecte (135) chauffe l'unité de collecte (115) à une température inférieure à celle de la partie de chauffage d'unité de collecte (131).

13. Appareil (100) selon l'une quelconque des revendications 1 à 12, comprenant en outre :

    un tube externe logeant le tube interne (110), le tube externe comportant, sur l'un de ses côtés, le dispositif d'entraînement (150) et, sur l'autre de ses côtés, le dispositif d'évacuation (140) et
    une partie d'étanchéité tenant de façon étanche une partie de couplage entre le dispositif d'entraînement (150) et le tube externe pour tenir de façon étanche le tube externe.

14. Appareil (100) selon l'une quelconque des revendications 1 à 13, comprenant en outre :

    un dispositif d'alimentation en gaz porteur fournissant un gaz porteur et configurer de telle sorte que le matériau de cible de purification sublimé ou évaporé soit déplacé vers le dispositif d'évacuation.

15. Appareil (100) selon l'une quelconque des revendications 1 à 14, dans lequel le tube interne (110) comprend une partie d'agrandissement de superficie pour agrandir une superficie à l'intérieur du tube interne (110).

16. Appareil (100) selon l'une quelconque des revendications 1 à 15, dans lequel le composé organique comprend un matériau pour un dispositif électroluminescent organique.

17. Procédé de purification d'un composé organique à l'aide de l'appareil selon les revendications 1 à 16, consistant :

    (a) à fournir un matériau de cible de purification à une unité d'alimentation (111) ;
    (b) à faire fondre le matériau de cible de purification ;
    (c) à faire tourner l'unité d'alimentation (111) pour former un mince film sur une paroi interne de l'unité d'alimentation ;
    (d) à sublimer ou à évaporer le matériau de cible de purification fourni à l'unité d'alimentation par la chaleur ; et
    (e) à purifier le matériau de cible de purification par sublimation ou liquéfaction du matériau de cible de purification tout en déplaçant le matériau de cible de purification vers un dispositif d'évacuation (140), dans lequel l'étape (d) de chauffage du matériau de cible de purification consiste à chauffer la pluralité de zones pour avoir différents gradients de température.

18. Procédé selon la revendication 17, dans lequel l'étape (a) de fourniture d'un matériau de cible de purification consiste à insérer l'unité d'alimentation (111) dans un tube externe et, ensuite, à empêcher l'air externe d'entrer dans l'unité d'alimentation (111) à l'aide d'une partie d'étanchéité.

19. Procédé selon la revendication 17 ou 18, dans lequel l'étape (d) de chauffage du matériau de cible de purification consiste à chauffer le tube interne (110) divisé en une pluralité de zones de telle sorte que la zone la plus éloignée du dispositif d'évacuation (140) présent une température égale ou supérieure à celle d'un point de sublimation ou d'évaporation du matériau de cible de purification et que les autres zones présentent une température inférieure à celle du point de sublimation ou d'évaporation.

20. Procédé selon l'une quelconque des revendications 17 à 19, dans lequel l'étape (c) de rotation de l'unité d'alimentation (111) consiste à faire tourner l'unité d'alimentation (111) après la fusion complète du matériau de cible de purification.

**FIG. 1**

**FIG. 2**

**FIG. 3**

**FIG. 4**

**FIG. 5**

**FIG. 6**

```
                      ┌─────────┐
                      │  START  │
                      └─────────┘
                           │
                           ▼
S10 ─── ┌─────────────────────────────────────┐
        │    SUPPLY PURIFICATION TARGET        │
        │    MATERIAL INTO SUPPLY UNIT         │
        └─────────────────────────────────────┘
                           │
                           ▼
S20 ─── ┌─────────────────────────────────────┐
        │  INSERT SUPPLY UNIT INTO OUTER TUBE  │
        │ AND BLOCK SUPPLY UNIT FROM EXTERNAL AIR │
        └─────────────────────────────────────┘
                           │
                           ▼
S25 ─── ┌─────────────────────────────────────┐
        │         OPERATE EVACUATOR            │
        └─────────────────────────────────────┘
                           │
                           ▼
S30 ─── ┌─────────────────────────────────────┐
        │   MELT PURIFICATION TARGET MATERIAL  │
        └─────────────────────────────────────┘
                           │
                           ▼
S40 ─── ┌─────────────────────────────────────┐
        │    FORM THIN FILM ON INNER WALL      │
        │  OF SUPPLY UNIT BY ROTATING SUPPLY UNIT │
        └─────────────────────────────────────┘
                           │
                           ▼
S50 ─── ┌─────────────────────────────────────┐
        │ HEAT PURIFICATION TARGET MATERIAL IN THE │
        │ SUPPLY UNIT TO BE SUBLIMATED OR EVAPORATED │
        └─────────────────────────────────────┘
                           │
                           ▼
S60 ─── ┌─────────────────────────────────────┐
        │ PURIFY PURIFICATION TARGET MATERIAL BY │
        │  SUBLIMATING OR LIQUEFYING PURIFICATION │
        │ TARGET MATERIAL WHILE MOVING PURIFICATION │
        │  TARGET MATERIAL TOWARD EVACUATOR.   │
        └─────────────────────────────────────┘
                           │
                           ▼
                      ┌─────────┐
                      │   END   │
                      └─────────┘
```

**FIG. 7**

**FIG. 8**

**FIG. 9**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 3840349 A
- US 2628892 A
- US 1445870 A
- US 3034573 A
- GB 509242 A
- FR 2704446 A1
- KR 0497448